# EUROPÄISCHE PATENTANMELDUNG

(11) **EP 1 901 424 A1**
(43) Veröffentlichungstag der Anmeldung: **19.03.2008**
(21) Anmeldenummer: 07013935.7
(22) Anmeldetag: 17.07.2007
(51) Int. Cl.: H03F 3/187, H03F 1/30, H03G 3/34

(54) **Schaltungsanordnung zur Unterdrückung von Einschaltgeräuschen**

(30) Priorität: 13.09.2006 DE 102006043746
(71) Anmelder: Micronas GmbH, 79108 Freiburg i. Br. (DE)
(72) Erfinder: Theus, Ulrich, 79194 Gundelfingen (DE); Kessel, Jürgen, 79102 Freiburg (DE)
(74) Vertreter: Patentanwälte Westphal, Mussgnug & Partner

(57) **Zusammenfassung**

Die Erfindung betrifft einen integrierten Audioverstärker mit den Merkmalen:
- einen Operationsverstärker (OP)
- der Operationsverstärker (OP) weist eine Eingangsstufe (ES) und eine Ausgangsstufe (AS) auf,
- die Ausgangsstufe (AS) verfügt über eine Kompensationskapazität (C),
- eine Vorladeeinrichtung (VE) zum Aufladen der Kompensationskapazität (C) auf eine vorgebbare Spannung, und
- eine Überwachungseinrichtung (SE), durch welche ein nicht betriebsbereiter Zustand des Audioverstärkers erkannt und die Vorladeeinrichtung (VE) aktiviert und zugleich die Ausgangsstufe (AS) solange gesperrt wird, bis die von der Vorladeeinrichtung (VE) zu ladende Kompensationskapazität (C) auf die vorgegebene Spannung aufgeladen ist.

Vorteil: Reduzierung bzw. Beseitigung von Einschaltgeräuschen.

## Beschreibung

Die Erfindung betrifft einen integrierten Audioverstärker, bei dem Einschaltgeräusche unterdrückt werden.

Integrierte Audioverstärker sind hinlänglich bekannt. Ein Beispiel in CMOS-Technologie ist beispielsweise in EP 0 460 263 A1 der Anmelderin beschrieben.

Problematisch bei den integrierten Audioverstärkern ist die Tatsache, dass bei deren Einschalten Einschaltgeräusche, insbesondere ein deutlich hörbares Knacken, auftreten. Auf der Geräteebene von Audioverstärkern wird dieses Problem üblicherweise dadurch gelöst, dass in der Lautsprecherleitung ein Relais vorhanden ist, das die Lautsprecher verzögert einschaltet. Diese Lösung eignet sich aber nicht für die Integration.

Aus der DE 195 03 881 A1 ist ein Stummschalter für einen Audioverstärker bekannt. Diese Stummschaltvorrichtung ist wiederum am Ausgang des Audioverstärkers angeordnet und dient zum Unterdrücken einer Schaltstörspannung im Ausgangssignal. Diese Stummschaltvorrichtung beinhaltet einen bipolaren Transistor, der als Kurzschlussschalter für die Impulsstörspannung ohne Vorspannung parallel zum Audioausgang angeordnet ist.

Die Erfindung hat das Ziel, einen integrierten Audioverstärker anzugeben, bei dem solche Einschaltgeräusche wirksam unterdrückt werden, indem die integrierte Schaltung des Audioverstärkers in geeigneter Weise hierfür angepasst wird.

Dieses Ziel wird durch einen integrierten Audioverstärker mit den Merkmalen des Anspruchs 1 gelöst.

Weiterbildungen eines solchen integrierten Audioverstärkers sind Gegenstand der Unteransprüche.

Der erfindungsgemäße integrierte Audioverstärker weist zur'Unterdrückung von Einschaltgeräuschen im Wesentlichen folgende Merkmale auf:
- einen Operationsverstärker,
- der Operationsverstärker verfügt über eine Eingangsstufe und eine Ausgangsstufe,
- die Ausgangsstufe besitzt eine Kompensationskapazität, welche mit dem Eingang und dem Ausgang der Ausgangsstufe in Verbindung steht,
- eine Vorladeeinrichtung zum Aufladen der Kompensationskapazität auf eine vorgegebene Spannung und
- eine Überwachungseinrichtung, durch welche ein Einschalten des Audioverstärkers erkannt und die Vorladeeinrichtung aktiviert sowie zugleich die Ausgangsstufe solange gesperrt wird, bis die Kompensationskapazität von der Vorladeeinrichtung auf die vorgegebene Spannung aufgeladen ist.

Die Erfindung geht dabei bevorzugt von Operationsverstärkerschaltungen mit Widerstandsgegenkopplung aus, die mit einfacher Betriebsspannung betrieben werden. Dies bedeutet, dass der Operationsverstärker an positives Betriebspotenzial und Massepotenzial zur Versorgung angeschlossen ist.

Bei den herkömmlichen Operationsverstärkern bzw. Audioverstärkern sind alle Spannungen im ausgeschalteten Zustand, d. h. bei abgeschalteter Betriebsspannung, auf dem Potenzial der negativen Betriebsspannung bzw. auf Massepotenzial, und die Ruheströme befinden sich auf Null. Insbesondere sind sowohl der Ausgang des Operationsverstärkers als auch die interne Verbindung zwischen der Eingangsstufe und der Ausgangsstufe im ausgeschalteten Zustand auf dem Potenzial der negativen Betriebsspannung also auf Bezugspotenzial, sofern die negative Betriebsspannung Massepotenzial ist. Im eingeschalteten Zustand des Operationsverstärkers bzw. Audioverstärkers beträgt die Spannung an der internen Verbindung zwischen Eingangsstufe und Ausgangsstufe mindestens etwa 0,5 V, wenn der Ausgang auf dem Potenzial der negativen Betriebsspannung ist.

Beim Übergang vom ausgeschalteten in den eingeschalteten Zustand wird die Gleichtaktspannung an den Eingängen und damit auch die Ausgangsspannung langsam auf etwa die halbe Betriebsspannung heraufgefahren. Dabei ist der Verstärker zunächst in einem noch nicht betriebsbereiten Zustand. Der betriebsbereite Zustand wird erst nach einer bestimmten, verhältnismäßig kurzen Zeitspanne erreicht. Gleichzeitig steigt der Ruhestrom aller Stufen innerhalb des Operationsverstärkers proportional zu einer ebenfalls von Null aus ansteigender Referenzspannung von Null auf den jeweiligen Nennwert. Nach dem Stand der Technik erfolgt der Übergang vom ausgeschalteten zum eingeschalteten Zustand so, dass die Spannung am Verbindungsknoten zwischen der Eingangsstufe und der Ausgangstufe Vorrang besitzt, also sofort auf ihren betriebsmäßigen Wert ansteigt. Bedingt durch einen zwischen Eingang und Ausgang der Ausgangsstufe des Operationsverstärkers vorgesehenen Kompensationskondensators, der noch nicht aufgeladen ist, steigt der Ausgang des Operationsverstärkers ebenfalls an. Durch die sehr große Eingangsdifferenzspannung wird der Tail-Strom der Eingangsstufe auf den Kompensationskondensator geleitet und lädt ihn auf. Dabei geht die Ausgangsspannung allmählich wieder auf das Potenzial der negativen Betriebsspannung zurück. Dieser Vorgang ist deutlich als Knacken beim Einschalten des integrierten Audioverstärkers hörbar.

Durch die erfindungsgemäße Lösung des integrierten Audioverstärkers wird der nicht betriebsgemäße Zustand des Potenzials am Verbindungsknoten zwischen Eingangsstufe und Ausgangsstufe erkannt. Die "normale" Funktion der Ausgangsstufe wird gesperrt und ein Strom durch den Kompensationskondensator geführt, damit dieser auf eine vorgegebene Spannung, die annähernd der betriebsgemäßen Spannung entspricht, aufgeladen wird. Ist dies erreicht, wird die "normale Funktion" der Ausgangsstufe freigegeben.

Durch die erfindungsgemäße Ausbildung des integrierten Audioverstärkers kann der Spannungsimpuls am Ausgang des Operationsverstärkers von etwa 500 mV auf ca. 25 mV und damit das Spannungsimpulsintegral über die Zeit reduziert werden. Ein unerwünschtes Knacken oder Einschaltgeräusch ist damit kaum mehr oder nicht mehr hörbar.

Im Nachfolgenden wird ein Ausführungsbeispiel des integrierten Audioverstärkers anhand von zwei Figuren näher erläutert. Es zeigen:
- Figur 1: ein Prinzipschaltbild des integrierten Audioverstärkers nach Erfindung, und
- Figur 2: ein konkretes Ausführungsbeispiel eines integrierten Audioverstärkers, mit dem Einschaltgeräusche wirksam unterdrückt werden können.

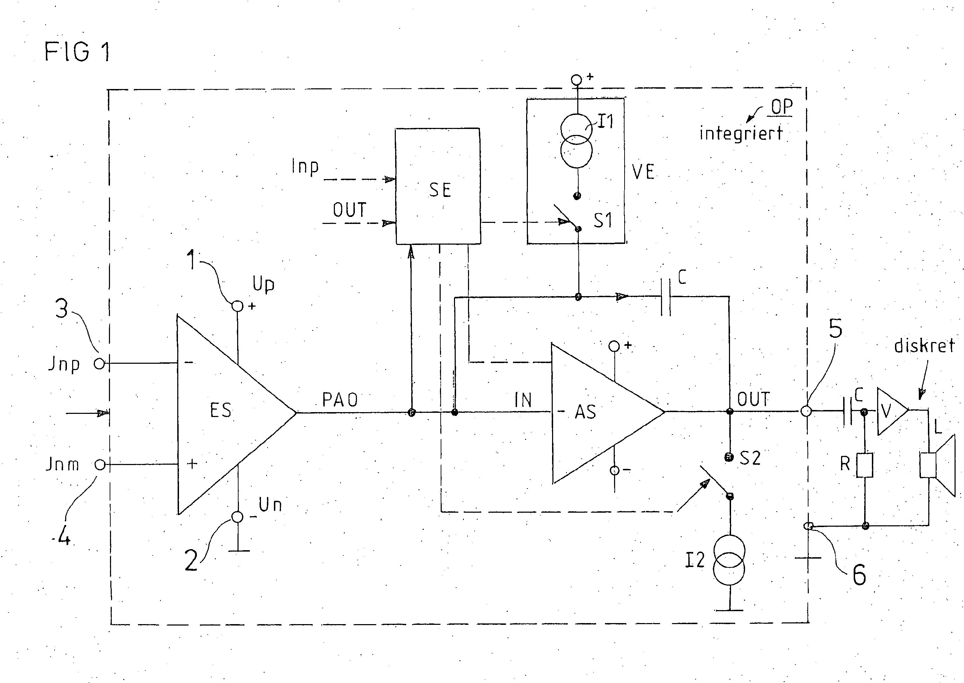

In Figur 1 ist das Prinzipschaltbild eines integrierten Audioverstärkers nach der Erfindung sehr vereinfacht dargestellt.

Der integrierte Audioverstärker weist einen Operationsverstärker OP mit einer Eingangsstufe ES und einer Ausgangsstufe AS auf. Die Eingangsstufe ES ist an eine erste Versorgungsklemme und eine zweite Versorgungsklemme 2 angeschlossen. An der ersten Versorgungsklemme 1 ist ein positives Betriebspotenzial Uₚ und an die zweite Versorgungsklemme ein negatives Versorgungspotenzial Uₙ angelegt. Das negative Versorgungspotenzial Uₙ ist im Ausführungsbeispiel das Massepotenzial. Die Eingangsstufe ES ist eine herkömmliche Differenzstufe mit zwei Eingangsklemmen 3, 4. Die Eingangsklemme 3 ist mit dem negativen Eingang und die Eingangsklemme 4 mit dem positiven Eingang der Eingangsstufe ES in Verbindung. An die beiden Eingangsklemmen 3, 4 wird ein Differenzeingangssignal angelegt, indem an die Eingangsklemme 3 ein erstes Eingangssignal Inp und an die zweite Eingangsquelle 4 ein zweites Eingangssignal Inm angelegt wird. Der Ausgang PAO der Eingangsstufe ES ist mit dem Eingang IN der Ausgangsstufe AS elektrisch gekoppelt, z. B. unmittelbar in Verbindung. Der Ausgang OUT der Ausgangsstufe AS ist mit einer Ausgangsklemme 5 des Operationsverstärkers in Verbindung. Eine andere Ausgangsklemme 6 des Operationsverstärkers OP liegt auf Massepotenzial. An die beiden Ausgangsklemmen 5, 6 des integrierten Audioverstärkers ist eine Lautsprecheranordnung L mit Verstärker V, Widerstand R und Trennkondensator C als diskrete Bauelemente, anschließbar. In für Operationsverstärker herkömmlicher Weise sind der Eingang IN und der Ausgang OUT der Ausgangsstufe AS mit einer Kompensationskapazität C überbrückt. Bisher ist ein herkömmlicher Operationsverstärker OP, der als Audioverstärker eingesetzt ist, beschrieben.

Problematisch bei einem solchen integrierten Audioverstärker ist die Tatsache, dass beim Einschalten bzw. in den Betrieb setzen des Audioverstärkers ein deutliches Einschaltgeräusch, insbesondere ein Knacken, im Lautsprecher L zu hören ist. Durch die im Folgenden beschriebenen Maßnahmen können diese Einschaltgeräusche deutlich reduziert werden. Der integrierte Audioverstärker ist hierfür um eine Überwachungseinrichtung SE und eine Vorladeeinrichtung VE erweitert. Die Vorladeeinrichtung VE verfügt über eine an positives Betriebspotenzial Up angeschlossene Stromquelle I1, welche über einen Schalter S1 an den mit dem Eingang der Ausgangsstufe AS verbundenen Anschluss der Kompensationskapazität C in Verbindung steht. Der Schalter S1 ist von der Überwachungseinrichtung SE ein- und ausschaltbar. Zusätzlich ist eine weitere Stromquelle I2 in Serie mit einem weiteren Schalter S2 von der Überwachungseinrichtung SE steuerbar. Dieser weitere Schalter S2 mit Stromquelle I2 befindet sich zwischen dem Ausgang OUT der Ausgangsstufe AS und der Ausgangsklemme 6. Die Überwachungseinrichtung SE überwacht, ob der integrierte Audioverstärker eingeschaltet wird. Im Ausführungsbeispiel von Figur 1 wird hierfür das am Ausgang PAO anliegende Signal der Eingangsstufe ES abgegriffen und der Überwachungseinrichtung SE zugeführt. Der Überwachungseinrichtung SE könnte, wie in Figur 1 dargestellt, als Steuersignale die Signale Inp und OUT zugeleitet werden.

Im "normalen" Betrieb sind die beiden Schalter S1 und S2 ausgeschaltet. Im ausgeschalteten Zustand des Audioverstärkers sind dagegen alle Spannungen auf dem Potenzial der negativen Betriebsspannung, also auf Massepotenzial, und die Ruheströme folglich auf Null. Insbesondere sind im ausgeschalteten Zustand sowohl der Ausgang OUT des gesamten Audioverstärkers als auch der Ausgang PAO der Eingangsstufe ES auf dem Potenzial der negativen Betriebsspannung. Im eingeschalteten bzw. betriebsbereiten Zustand liegt am Ausgang PAO der Eingangsstufe ES beispielsweise mindestens 0,5 V an, wobei der Ausgang OUT sich immer noch auf dem Potenzial der negativen Betriebsspannung befindet. Bedingt durch den noch nicht aufgeladenen Kompensationskondensator C steigt das Ausgangssignal OUT ebenfalls sehr schnell auf diesen Wert an. Anschließend geht die Ausgangsspannung allmählich wieder auf das Potenzial der negativen Betriebsspannung zurück, und zwar insoweit, als die Kompensationskapazität C aufgeladen wird, und zwar durch den Strom, der von der Eingangsstufe ES geliefert wird.

Diesen Zustand erkennt die erfindungsgemäße Anordnung von Figur 1, indem die Überwachungseinrichtung SE das Signal am Ausgang PAO der Eingangsstufe ES abgreift. Wenn nach dem Einschalten des Audioverstärkers das Potenzial am Ausgang PAO die erwähnten mindestens 0,5 V wesentlich unterschreitet, sorgt die Überwachungseinrichtung SE dafür, dass der Schalter S2 in dieser Zeit geschlossen ist und der Schalter S1 ebenfalls geschlossen ist. Durch das gleichzeitige Schließen des Schalters S1 wird ein Strom I1 von der Stromquelle I1 der Vorladeeinrichtung VE durch den Kompensationskondensator C geleitet, bis dieser auf eine vorgegebene Spannung aufgeladen ist, und über den Schalter S2 als Strom I2 abgeleitet. Dabei ist zweckmäßigerweise der Strom I1 gleich dem Strom I2. Diese vorgegebene Spannung kann beispielsweise eine betriebsgemäße Spannung sein. Erst wenn der Kompensationskondensator C auf diese vorgegebene Spannung aufgeladen ist, wird die normale Funktion der Ausgangsstufe AS freigegeben, indem die Schalter S1 und S2 wieder öffnen. Der Spannungsimpuls am Ausgang OUT wird dadurch von ca. 500 mV auf etwa 25 mV reduziert. Dieser Spannungspuls ist damit praktisch nicht mehr hörbar.

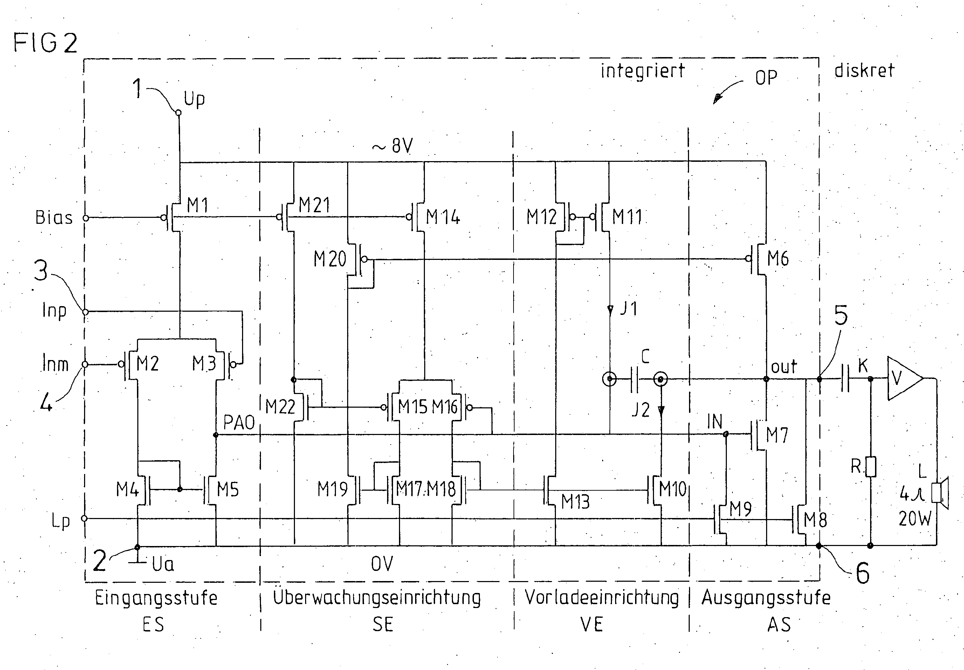

Im Zusammenhang mit der Figur 2 wird ein detailliertes Beispiel eines in CMOS-Technologie realisierten integrierten Audioverstärkers nach der Erfindung erläutert.

Der in Figur 2 dargestellte Operationsverstärker OP verfügt wie die Anordnung in Figur 1 über eine Eingangsstufe ES, eine Überwachungseinrichtung SE, eine Vorladeeinrichtung VE und eine Ausgangsstufe AS. Der integrierte Schaltkreis verfügt über zwei Versorgungsklemmen 1, 2. Die erste Versorgungsklemme 1 ist an positives Betriebspotenzial Up und die zweite Versorgungsklemme 2 an negatives Betriebspotenzial Uₙ, vorliegend Massepotenzial, angeschlossen. In bereits erläuterter Weise sind zwei Eingangsklemmen 3, 4 vorgesehen, an die die Eingangssignale Inp und Inm anzulegen sind. Ausgangsseitig sind die beiden Ausgangsklemmen 5, 6 vorgesehen.

Die Eingangsstufe ES weist die Serienschaltung einer Eingangsstromquelle mit einem p-Kanal-Transistor M1, der an die Versorgungsklemme 1 angeschlossen ist, und einer p-Kanaldifferenzstufe mit den p-Kanal-Transistoren M2 und M3 auf. Der Steueranschluss des p-Kanal-Transistors M2 ist mit der Eingangsklemme 4 und der Steueranschluss des p-Kanal-Transistors M3 mit der Eingangsklemme 3 verbunden. Die beiden p-Kanal-Transistoren M2 und M3 sind über einen n-Kanal-Stromspiegel mit den n-Kanal-Transistoren M4 und M5 an die zweite Versorgungsklemme 2 angeschlossen. Dabei ist der Eingang dieses n-Kanal-Stromspiegels mit dem p-Kanal-Transistor M2 und der Ausgang des n-Kanal-Stromspiegels mit dem Ausgang PAO in Verbindung. Der Steueranschluss des ersten Transistors M1 ist mit einer Klemme Bias in Verbindung, an die ein Hilfspotenzial angelegt wird. Der Verbindungspunkt zwischen dem Transistor M3 der p-Kanal-Differenzstufe und dem Transistor M5 des n-Kanal-Stromspiegels ist der Ausgang PAO der Eingangsstufe ES.

Die Ausgangsstufe AS des integrierten Audioverstärkers weist im Wesentlichen die zwischen die Klemmen 1 und 2 bzw. 6 geschaltete Serienschaltung der Laststrecken eines p-Kanal-Transistors M6 mit einem n-Kanal-Transistor M7 auf. Der Steueranschluss des n-Kanal-Transistors M7 ist der Eingang IN der Ausgangsstufe AS und zugleich mit dem Ausgang PAO der Eingangsstufe ES in Verbindung. Der Ausgang der Ausgangsstufe AS und damit der Ausgang des integrierten Audioverstärkers ist mit OUT bezeichnet und zugleich der Verbindungspunkt des Transistors M6 und des Transistors M7. Dieser Ausgang OUT ist mit der ersten Ausgangsklemme 5 in Verbindung. Die zweite Ausgangsklemme 6 liegt auf Massepotenzial und ist deshalb mit der zweiten Versorgungsklemme 2 in Kontakt. Zusätzlich verfügt die Ausgangsstufe AS noch über die Kompensationskapazität C, die zwischen den Eingang IN und den Ausgang OUT der Ausgangsstufe AS geschaltet ist.

Ein weiterer n-Kanal-Transistor M8 ist mit seiner Laststrecke zwischen die beiden Ausgangsklemmen 5, 6 geschaltet. Ein neunter n-Kanal-Transistor M9 ist zwischen den Eingang IN der Ausgangsstufe AS und die Ausgangsklemme 6 geschaltet. Die Steueranschlüsse dieser beiden Transistoren M8 und M9 stehen mit einer eingangsseitigen Klemme, an die ein Standby-Signal anlegbar ist, in Verbindung, an die ein Hilfssignal anschließbar ist, zum Deaktivieren der Ausgangsstufe AS.

Die aus Figur 1 bekannte gesteuerte Stromquelle I2 mit dem Schalter S2 ist in der Schaltungsanordnung von Figur 2 als n-Kanal-Transistor M10 ausgebildet, welcher als Stromquelle dient und mit seiner Laststrecke zwischen den Ausgang OUT der Ausgangsstufe AS und die Ausgangsklemme 7 geschaltet ist. Der n-Kanal-Transistor M10 liefert den aus Figur 1 bekannten Strom 12.

Die Vorladeeinrichtung VE verfügt über einen Stromspiegel mit den p-Kanal-Transistoren M11 und 12. Anschlüsse der beiden p-Kanal-Transistoren M11 und M12 sind mit der Versorgungsklemme 1 in Kontakt. Der Eingang des Stromspiegels, d. h. der andere freie Eingang des Transistors M12 ist über die Laststrecke eines weiteren n-Kanal-Transistors M13 an die zweite Versorgungsklemme 2 angeschlossen. Der Ausgang des Stromspiegels, d. h. der andere freie Anschluss des p-Kanal-Transistors M11 ist mit den beiden Klemmen PAO der Eingangsstufe ES und der Eingangsklemme IN der Ausgangsstufe AS in Verbindung. An diesem Ausgang des Stromspiegels ist der im Zusammenhang mit Figur 1 bereits erläuterte Strom I1 abgreifbar.

Die Überwachungseinrichtung SE verfügt über eine weitere Stromquelle in Form des p-Kanal-Transistors M14, der an die Versorgungsklemme 1 angeschlossen ist. Der andere Anschluss der Laststrecke p-Kanal-Transistors M14 ist über eine p-Kanal-Differenzstufe mit den Transistoren M15, M16 über jeweils einen zur Diode geschalteten n-Kanal-Transistor M17 und M18 mit der zweiten Versorgungsklemme 2 in Verbindung. Der Steueranschluss des p-Kanal-Transistors M16 ist mit den Anschlüssen PAO und IN in Verbindung. Der Steueranschluss des p-Kanal-Transistors M15 erhält ein vorgegebenes Potenzial in noch zu erläuternder Weise.

Der Steueranschluss n-Kanal-Transistors M17 ist mit dem Steueranschluss eines weiteren n-Kanal-Transistors M19 in Verbindung. Die Laststrecke dieses weiteren Transistors M19 ist einerseits an die zweite Versorgungsklemme 2 und andererseits über einen p-Kanal-Transistors M20 an die erste Versorgungsklemme 1 geschaltet. Der Verbindungspunkt zwischen den Transistoren M19 und M20 ist mit dem Steueranschluss des p-Kanal-Transistors M20 in Verbindung und mit dem Steueranschluss des p-Kanal-Transistors M6 der Ausgangsstufe AS. Damit bilden die Transistoren M6 und M20 einen Stromspiegel. Der Steueranschluss M18 ist mit den Steueranschlüssen der Transistoren M10 und M13 in Verbindung. Schließlich verfügt die Schaltungsanordnung von Figur 2 noch über eine weitere Stromquelle in Form eines p-Kanal-Transistors M21, welche mit seinem einen Anschluss seiner Laststrecke an die Versorgungsklemme 1 und seinem anderen Anschluss der Laststrecke über die Laststrecke eines Transistors M22 mit der Versorgungsklemme 2 in Verbindung steht. Der Steueranschluss des p-Kanal-Transistors M21 ist - wie der Steueranschluss des p-Kanal-Transistors M14 mit der Klemme Bias in Verbindung. Der Steueranschluss des Transistors M22 ist mit dem Steueranschluss des Transistors M15 und mit dem Verbindungspunkt der Laststrecken des Transistors M21 und M22 in Kontakt.

An die beiden Ausgangsklemmen 5, 6 des integrierten Audioverstärkers ist die Serienschaltung eines Trennkondensators K mit einem Verstärker V und einem Lautsprecher L angeschlossen. Zusätzlich ist zwischen dem Verbindungspunkt des Trennkondensators K und dem Verstärker V und die Ausgangsklemme 6 die Ausgangsstufe AS ein Widerstand R geschaltet. Die Funktionsweise der in Figur 2 dargestellten integrierten Schaltungsanordnung ist folgende:

Die Überwachungseinrichtung SE erkennt den besonderen Zustand beim Einschalten und steuert entsprechend die Vorladeeinrichtung VE und die Ausgangsstufe AS. Die Transistoren M21 und M22 sind so dimensioniert, dass die Gate-Source-Spannung des n-Kanal-Transistors M22 kleiner als die betriebsmäßige Spannung am Ausgang PAO der Eingangsstufe ES ist. Damit wird im normalen Betrieb der Strom aus dem p-Kanal-Transistor M14 über die Transistoren M15, M17 und M19 sowie M20 zum Ruhestrom der Ausgangsstufe AS. Im Übergang vom stromlosen zum aktiven Zustand ist das Potenzial am Ausgang PAO der Eingangsstufe ES zunächst noch auf 0 V. Der Strom vom Transistor M14 wird in diesem Fall über die Transistoren M16 und M18 in die Vorladeeinrichtung VE gegeben. Die Vorladeeinrichtung VE schickt diesen Strom mittels der Transistoren M13, M12 und M11 in den Kompensationskondensator C, von wo er am anderen Anschluss des Kompensationskondensators C über den Transistor M10 wieder abgeführt wird.

Wenn die Spannung über den Kompensationskondensator C die Gate-Source-Spannung am Transistor M22 erreicht hat, wird dieser Vorladevorgang der Kompensationskapazität C beendet, und die Schaltung geht in den normalen Betrieb über, ohne dass eine wesentliche Spannungsspitze am Ausgang OUT auftritt.

Durch eine solche Anordnung kann das Einschaltknacken um ca. 26 dB reduziert werden.

Einsetzbar ist die erfindungsgemäße integrierte Audioverstärkerschaltung bei allen Audio-Ausgangsstufen vom Line-Out-Typ, die ohne zwischengeschaltete Lautstärkenregelung mit den Endverstärkern verbunden sind.

### Bezugszeichenliste

- 1: Versorgungsklemme
- 2: Versorgungsklemme
- 3: Eingangsklemme
- 4: Eingangsklemme
- 5: Ausgangsklemme
- 6: Ausgangsklemme
- AS: Ausgangsstufe
- Bias: Hilfspotenzial
- C: Kompensationskapazität
- ES: Eingangsstufe
- I1: Strom in die Kompensationskapazität
- I2: Strom aus der Kompensationskapazität
- IN: Eingangssignal der Ausgangsstufe AS
- Inp: Eingangssignal an der ersten Eingangsklemme 3 der Eingangsstufe ES
- Inm: Eingangssignal an der zweiten Eingangsquelle 4 der Eingangsstufe ES
- K: Koppelkapazität
- L: Lautsprecher
- Lp: Schaltsignal
- M1: erster Transistor
- M2: zweiter Transistor
- M3: dritter Transistor
- M4: vierter Transistor
- M5: fünfter Transistor
- M6: sechster Transistor
- M7: siebter Transistor
- M8: achter Transistor
- M9: neunter Transistor
- M10: zehnter Transistor
- M11: elfter Transistor
- M12: zwölfter Transistor
- M13: dreizehnter Transistor
- M14: vierzehnter Transistor
- M15: fünfzehnter Transistor
- M16: sechzehnter Transistor
- M17: siebzehnter Transistor
- M18: achtzehnter Transistor
- M19: neunzehnter Transistor
- M20: zwanzigster Transistor
- M21: einundzwanzigster Transistor
- M22: zweiundzwanzigster Transistor
- OP: Operationsverstärker
- OUT: Ausgangssignal der Ausgangsstufe AS
- Uₙ: negatives Versorgungspotenzial
- Uₚ: positives Versorgungspotenzial
- SE: Detektionseinrichtung
- V: externer Verstärker
- VE: Vorladeeinrichtung
- I: Stromquelle
- S1: Schalter
- S2: Schalter
- Lp: Standby-Steuersignal
- R: Widerstand

## Patentansprüche

1. Integrierter Audioverstärker mit Unterdrückung von Einschaltgeräuschen und den Merkmalen:
- ein Operationsverstärker (OP)
- der Operationsverstärker (OP) weist eine Eingangsstufe (ES) und eine Ausgangsstufe (AS) auf,
- die Ausgangsstufe (AS) verfügt über eine Kompensationskapazität (C),
- eine Vorladeeinrichtung (VE) zum Aufladen der Kompensationskapazität (C) auf eine vorgebbare Spannung, und
- eine Überwachungseinrichtung (SE), durch welche ein nicht betriebsbereiter Zustand des Audioverstärkers erkannt und die Vorladeeinrichtung (VE) aktiviert und zugleich die Ausgangsstufe (AS) solange gesperrt wird, bis die von der Vorladeeinrichtung (VE) zu ladende Kompensationskapazität (C) auf die vorgegebene Spannung aufgeladen ist.

2. Integrierter Audioverstärker nach Anspruch 1,
**dadurch gekennzeichnet, dass** dieser in CMOS-Technologie realisiert ist.

3. Integrierter Audioverstärker nach Anspruch 1 oder 2,
**dadurch gekennzeichnet, dass** die Eingangsstufe (ES) als Differenzverstärker ausgebildet ist.

4. Integrierter Audioverstärker nach Anspruch 3,
**dadurch gekennzeichnet, dass** der Differenzverstärker der Eingangsstufe (ES) eine Serienschaltung einer Eingangsstromquelle mit einem ersten Transistor (M1), einer Differenzstufe mit einem zweiten Transistor (M2) und dritten Transistor (M3), sowie einen Stromspiegel mit einem vierten Transistor (M4) und einem fünften Transistor (M5) aufweist, wobei diese Serienschaltung zwischen zwei Versorgungsklemmen (1, 2) angeschlossen ist und an diese beiden Versorgungsklemmen (1, 2) ein erstes Versorgungspotenzial (Up) und ein zweites Versorgungspotenzial (Uₙ) anzulegen ist.

5. Integrierter Audioverstärker nach Anspruch 4,
**dadurch gekennzeichnet, dass** an die Differenzstufe mit dem zweiten Transistor (M2) und dritten Transistor (M3) zwei Eingangsklemmen (3, 4) zum Anlegen einer Eingangsdifferenzspannung angeschlossen sind.

6. Integrierter Audioverstärker nach einem der Ansprüche 1 bis 5,
**dadurch gekennzeichnet, dass** der Audioverstärker zwei Ausgangsklemmen (5, 6) aufweist und eine dieser Ausgangsklemmen (5, 6) mit einer der Versorgungsklemmen (2) in Verbindung steht.

7. Integrierter Audioverstärker nach Anspruch 6,
**dadurch gekennzeichnet, dass** zwischen die beiden Ausgangsklemmen (5, 6) eine externe Audiostufe mit Lautsprecher (L) angeschlossen ist.

8. Integrierter Audioverstärker nach einem der Ansprüche 1 bis 7,
**dadurch gekennzeichnet, dass** die Ausgangsstufe (AS) des integrierten Audioverstärkers die Serienschaltung eines sechsten Transistors (M6) mit einem siebten Transistor (M7) vorsieht, wobei die Serienschaltung zwischen die Versorgungsklemmen (1, 2) geschaltet ist und ein Verbindungspunkt des sechsten Transistors (M6) mit dem siebten Transistor (M7) mit einer der beiden Ausgangsklemmen (5) in Verbindung steht.

9. Integrierter Audioverstärker nach einem der Ansprüche 1 bis 8,
**dadurch gekennzeichnet, dass** die Kompensationskapazität (C) zwischen einem Eingang (IN) und einem Ausgang (OUT) der Ausgangsstufe (AS) angeschlossen ist.

10. Integrierter Audioverstärker nach Anspruch 9,
**dadurch gekennzeichnet, dass** die wirksame Steuerspannung der Ausgangsstufe (AS) zwischen dem Eingang (IN) und der Ausgangsklemme (6) abgreifbar ist.

11. Integrierter Audioverstärker nach Anspruch 9 oder 10,
**dadurch gekennzeichnet, dass** der mit dem Eingang (IN) der Ausgangsstufe (AS) verbundene Anschluss der Kompensationskapazität (C) mit einem Ausgang (PAO) der Eingangsstufe (ES) in Verbindung steht und insbesondere ein Eingangsstrom (I1) in die Kompensationskapazität (C) einem Ausgangsstrom (I2) aus der Kompensationskapazität (C) entspricht.

12. Integrierter Audioverstärker nach einem der Ansprüche 1 bis 11,
**dadurch gekennzeichnet, dass** die Vorladeeinrichtung (VE) einen zehnten Transistor (M10) als Stromquelle aufweist, welche zwischen die Ausgangsklemmen (5, 6) geschaltet ist.

13. Integrierter Audioverstärker nach einem der Ansprüche 1 bis 12,
**dadurch gekennzeichnet, dass** die Vorladeeinrichtung (VE) einen Stromspiegel mit einem elften Transistor (M11) und einem zwölften Transistor (M12) aufweist, welcher mit der an positives Potenzial (Up) versorgten Versorgungsklemme (1) in Verbindung steht und eingangsseitig über einen dreizehnten Transistor (M13) mit der anderen Versorgungsklemme (2) verbunden ist und ausgangsseitig mit derjenigen Anschlussklemme der Kompensationskapazität (C) in Verbindung steht, welche sowohl mit dem Eingang (IN) der Ausgangsstufe (AS) als auch dem Ausgang (PAO) der Eingangsstufe (ES) verbunden ist.

14. Integrierter Audioverstärker nach einem der Ansprüche 1 bis 13,
**dadurch gekennzeichnet, dass** der zehnte Transistor (M10) und der dreizehnte Transistor (M13) jeweils Steueranschlüsse aufweisen, die mit einem Ausgang der Überwachungseinrichtung (SE) in Verbindung stehen.

15. Integrierter Audioverstärker nach einem der Ansprüche 1 bis 14,
**dadurch gekennzeichnet, dass** die Überwachungseinrichtung (SE) einen vierzehnten Transistor (M14) als Stromquelle in Serie mit einer weiteren Differenzstufe, die einen fünfzehnten Transistor (M15) und einen sechzehnten Transistor (M16) aufweist, aufweist und der fünfzehnte Transistor (M15) und der sechzehnte Transistor (M16) über einen siebzehnten Transistor (M17) und einen achtzehnten Transistor (M18) an die Versorgungsklemme (2), die mit negativem Versorgungspotenzial (Uₙ) in Verbindung steht, angeschlossen sind.

16. Integrierter Audioverstärker nach Anspruch 15,
**dadurch gekennzeichnet, dass** die Überwachungseinrichtung (SE) die Serienschaltung von Laststrecken eines neunzehnten Transistors (M19) und eines zwanzigsten Transistors (M20) aufweist, wobei diese Serienschaltung zwischen die beiden Versorgungsklemmen (1, 2) geschaltet ist, und ein Steueranschluss des neunzehnten Transistors (M19) mit einem Steueranschluss des siebzehnten Transistors (M17) und ein Steueranschluss des zwanzigsten Transistors (M20) mit einem Steueranschluss des sechsten Transistors (M6) der Ausgangsstufe (AS) und auch mit dem neunzehnten Transistor (M19) in Verbindung steht.
